# EUROPEAN PATENT APPLICATION

(11) **EP 4 718 090 A1**
(43) Date of publication of application: **01.04.2026**
(21) Application number: 25189325.1
(22) Date of filing: 14.07.2025
(51) Int. Cl.: G01R 31/307

(54) **COMPENSATOR FOR INTERNAL ELECTROMAGNETIC INTERFERENCE IN SEM-BASED AC PROBING**

(30) Priority: 26.09.2024 US 202418896960
(71) Applicant: INTEL Corporation, Santa Clara, CA 95054 (US)
(72) Inventor: COX, Thaddeus, Portland, 97239 (US); MORGAN, Christopher, Portland, 97229 (US); SENGER, Mitchell, Beaverton, 97003 (US)
(74) Representative: Viering, Jentschura & Partner mbB Patent- und Rechtsanwälte

(57) **Abstract**

Disclosed herein are devices, systems, and methods for cancelling an internal magnetic field caused by a test signal within a test chamber of a scanning electron microscope (SEM). A compensator device includes a set of one or more wire loops around a test chamber and an amplifier configured to drive a current in each wire loop of the set of one or more wire loops. The compensator device also includes a control circuit configured to adjust, via the amplifier, a corresponding amplitude modulation of the current in each wire loop, wherein the control circuit is configured to adjust the corresponding amplitude modulation based on a test signal within the test chamber.

## Description

### Technical Field

The disclosure relates generally to compensation for electromagnetic interference (EMI) and in particular, to a compensator for internal EMI that may occur when probing a device under test (DUT) with an alternating current (AC) test signal when using a scanning electron microscope (SEM).

### Background

Scanning electron microscopes (SEMs) may be used in a fault isolation (FI) process, where faulty samples may be probed using cell-level or single-device nanoprobing (nP) and/or electron beam probing (EBP) techniques. In such an FI process, test signals provided within the test chamber, usually provided on nanoprobe tips or on many tester pins of a test board, may be driven with one or many AC signals to facilitate in-situ electrical testing of the device under test. As a result of the AC test signals, the electron beam trajectory of the SEM may be impacted by the dynamic electromagnetic fields generated by the test signal within the chamber, which in turn may cause periodic distortions, generally referred to herein as internal electromagnetic interference (IEMI), in the SEM image. IEMI may manifest itself as double images, vibrations, flagging, etc. As a result, IEMI may disrupt the SEM's ability to gather useful FI data.

### Brief Description of the Drawings

In the drawings, like reference characters generally refer to the same parts throughout the different views. The drawings are not necessarily to scale, emphasis instead generally being placed upon illustrating the exemplary principles of the disclosure. In the following description, various exemplary aspects of the disclosure are described with reference to the following drawings, in which:
FIG. 1 shows an example of an IEMI compensator system that may be used to reduce the IEMI in a SEM-based FI setup;
FIGs. 2A, 2B, and 2C illustrate examples of an SEM image and graphs of the amplitude of a test signal (*V_{S}*), a compensation signal (*V_{H}*)*,* and a magnetic field (*Bᵢₙₜ*)*,* each in different scenarios; and
FIG. 3 shows an example schematic flow diagram of a method for cancelling an internal magnetic field caused by a test signal within a test chamber of a scanning electron microscope (SEM).

### Description

The following detailed description refers to the accompanying drawings that show, by way of illustration, exemplary details and features.

The word "exemplary" is used herein to mean "serving as an example, instance, or illustration." Any aspect or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (*e.g*., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (*e.g.,* "plural [elements]", "multiple [elements]") referring to a quantity of elements expressly refers to more than one of the said elements. For instance, the phrase "a plurality" may be understood to include a numerical quantity greater than or equal to two (*e.g*., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, *e.g.,* provided as a file, a portion of a file, a set of files, a signal or stream, a portion of a signal or stream, a set of signals or streams, and the like. Further, the term "data" may also be used to mean a reference to information, *e.g.,* in the form of a pointer. The term "data", however, is not limited to the aforementioned examples and may take various forms and represent any information as understood in the art.

The terms "processor" or "controller" as, for example, used herein may be understood as any kind of technological entity (e.g., hardware, software, and/or a combination of both) that allows handling of data. The data may be handled according to one or more specific functions executed by the processor or controller. Further, a processor or controller as used herein may be understood as any kind of circuit, *e.g.,* any kind of analog or digital circuit. A processor or a controller may thus be or include an analog circuit, digital circuit, mixed-signal circuit, software, firmware, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (*e.g.,* a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPoint^{™}, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (*e.g.,* the transmission of radio signals) and logical transmission (*e.g.,* the transmission of digital data over a logical software-level connection). For example, a processor or controller may transmit or receive data over a software-level connection with another processor or controller in the form of radio signals, where the physical transmission and reception is handled by radio-layer components such as radio frequency (RF) transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both "direct" calculations via a mathematical expression/formula/relationship and 'indirect' calculations via lookup or hash tables and other array indexing or searching operations. References to the TX/RX "chain" or "path" refer to the series of processing steps to convert, modulate, amplify, filter, etc. the data signal to be transmitted (along the TX path) from the antenna or to the series of processing steps to convert, modulate, amplify, filter, etc. the desired signal (along the RX path) that is to be recovered from the received signal at the antenna. References to a "desired" signal refer to the predefined signal that is to be received by the communication device at the prescribed time.

In general, SEMs function by scanning/rastering an electron beam across a sample while detecting electrons, including backscattered electrons and secondary electrons, emitted by the sample in response to the beam. Ideally, the trajectory of the incident beam of electrons is determined only by the accelerating fields in the SEM column and the electromagnetic fields of the SEM's lenses. However, in practice, it is common for unwanted, environmentally driven, AC and DC magnetic fields to perturb the incident electron beam trajectory. The unwanted fields, usually called electromagnetic interference (EMI), may cause unaccountable shifting in the beam's path which has the effect of distorting the final SEM image. Generally, direct current (DC) EMI may not be detrimental because it generates an overall offset to the center of the beam's raster, which may be accounted for by a lens offset or a small stage movement. On the other hand, AC fields may have the propensity to create large issues for SEM imaging. Depending on the frequency of the environmental AC fields, SEM images taken in the presence of AC EMI may include distortions such as flagging (small vibrations apparent on the edges of objects in the SEM image) and blurring. Special care may be taken when installing a SEM in a laboratory or fab environment to prevent environmental EMI from interfering with the tool's ability to operation at specified capability. Generally, areas of the installation space with large EMI (near elevators, power transformers, etc.) are avoided. In situations where these areas cannot be avoided, environmental EMI cancellation systems may be installed around the SEM to isolate it from the environmental EMI.

Generally, an environmental EMI cancellation system may include multiple wire loops (also called Helmholtz coils), that may carry a mixed AC/DC signal and an environmental EMI detector that may be placed near the SEM column, for example on the tool's chassis. The coils may be placed about the SEM such that the magnetic fields generated by the coils may be directed along three ortho-normal axes. The environmental EMI detector signal may be fed back to an amplifier that is connected to the coils. The amplifier generates a set of signals on the coils which in turn generate a reciprocal field to the field detected at the SEM column, effectively zeroing the total field and thus mitigating the image-distortion effects of the environmental EMI.

As noted above, there are a class of tools that leverage SEMs for an FI process, where a device under test within the SEM chamber may be driven with test signals from a signal provider, including signal providers such as nanoprobe tips or a test board with many tester pins. The test signals may be AC test signals to facilitate in-situ electrical testing. The two main categories of these tools are nanoprobers (nP) and electron-beam probers (EBP). nP tools are equipped with several probes in the SEM chamber that may be remotely controlled by the user to land on a de-processed die. The probes may be configured to carry AC voltage test signals to drive single transistors or whole cells in so-called cell-level probing (AC-CLP). EBP tools host a set of tester boards that may socket an active unit. The tester may run many AC test signals to the DUT while the SEM beam is landed on the sample to generate a frequency map or capture a waveform from features on the unit. While the test signal delivery systems of these two tools are different, both may be subject to internal electromagnetic interference (IEMI) generated by the probes or tester boards within the SEM chamber.

Like external or environmental EMI, the IEMI may generate unwanted distortions to the SEM image that are similar to those discussed above with respect to the environmental EMI. Unlike environmental EMI, however, IEMI may not be canceled by environmental EMI cancellation systems because an environmental EMI detector may not detect the distorting magnetic fields generated *within* the chamber. In addition, the magnitude of IEMI distortions may be much stronger than the environmental EMI because the field sources of IEMI are much closer to the incident point of the beam (e.g., they may be ~1 µm away from the incident electron beam). As a result, the electron beam trajectory of the SEM may be negatively impacted by the AC electromagnetic fields generated by the test signals provided at the DUT in the chamber, causing IEMI distortions in the SEM image.

Conventional techniques for addressing this problem are not necessarily satisfactory. In cell-level nanoprobing (nP), one technique is for the AC test signal that drives the circuit to be fed to the DUT using only one probe tip. Then, the nP operator may attempt to compensate for the AC field by a applying the same AC test signal to one or several other, compensatory, probe tips on the nP. The operator may tune the total electromagnetic field generated by the signal application tip and compensator tip(s) at the location within the region of interest (ROI) by moving the compensator tip about the chamber and varying the signal until the distortion is diminished. In order to make this type of compensation effective, the process involves a tedious and meticulous probe placement process and increases throughput time for completing AC probing work for the FI process. In addition, one or more probe tips must be utilized as for the one or more "compensation" probes, which means they cannot be used for running or collecting signals from the DUT or other DUTs.

Another conventional technique for attempting to reduce IEMI distortion in cell-level nP is to reduce the duty cycle of the AC test signal applied to a probe tip, which may in turn reduce the magnitude of the IEMI distortion. For example, in the case where a probe tip is running a square wave test signal, an image captured by the SEM may display a double image. The intensity of the doubled features varies as a function of the relative time spent in the split positions. When the square wave has a 50/50 duty cycle, for example, the doubled features may present with the same intensity because they are splitting time evenly between the two positions. As another example, when the square wave has a 20/80 duty cycle signal, the features in one position may have four times the intensity as compared with the other position because the beam is spending four times longer in one position compared to the other position. While this type of signal may preserve the AC behavior of most circuitry while simultaneously mitigating the distortion created by the AC signal, the signal to noise ratio (SNR), especially for frequency mapping and waveform capture applications, for the signals of interest may scale with duty cycle and may be maximized at a 50/50 duty cycle. Thus, decreasing the distortion with this method may also have the effect of decreasing the useful signal strength.

For EBP applications, the types of distortions may be more complicated than the nP case since they may relate to the detailed temporal structure of the many test signals running through an active DUT. These effects may be mitigated by image capture techniques that are selective to certain times of interest. For example, if the SEM beam's periodic path amid the IEMI may be characterized, and SEM imaging or other time-averaged data collection may be isolated to short times within the IEMI period where the beam's position is known. However, time-of-interest (TOI) techniques in SEM-based FI applications are not well defined, remain under study and development, and are not widely used.

To address IEMI distortions, the compensator disclosed in more detail below uses a set of (e.g., one or more) external wire loops (e.g., Helmholtz coils) that carry a configurable waveform (e.g., based on the test signal provided to the probe tip, test board, or the device under test within the chamber). For example, a set of three wire loops (e.g., a 3-axis Helmholtz loop) may be driven by an amplifier which may drive each of the three wire loops with independent and arbitrary waveforms (e.g., via an arbitrary waveform generator or "AWG"). The compensator may modulate the amplitude of the signal carried by each of the three wire loops to tune the electromagnetic compensation in three dimensions (each dimension associated with a different one of the wire loops) in order to provide effective distortion removal. The modulation of the waveform on each wire loop may be tuned to match and cancel IEMI observed when imaging a DUT subject to one or many AC test signals of an SEM-based FI tool. The advantage of such a compensator over conventional methods is that that the compensator may provide for the total cancellation of IEMI within the probe tool's chamber at the ROI, which means that it may remove double images and flagging of image-based data collections on SEM FI tools, where the distortions are caused by AC signaling that is internal to the chamber. In addition, the disclosed compensator need not occupy a valuable probe tip because a compensator signal is not needed within the chamber, the compensator need not leverage time-of-interest probing, and the compensator need not sacrifice SNR by using low-duty cycle test signals in AC probing applications.

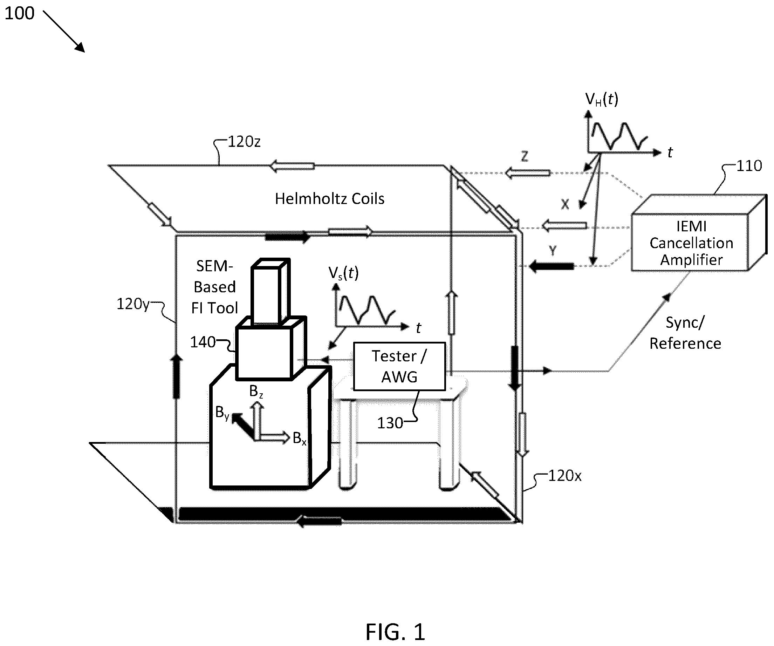

An example IEMI compensator system 100 is shown in FIG. 1 that may be used to reduce the IEMI in a SEM-based FI setup. An IEMI cancellation amplifier 110 may drive three wire loops 120x, 120y, 120z, each arranged along a different axis with respect to the SEM-based FI tool 140 of a device under test (DUT). The DUT may be probed with AC test signals (e.g., via a test probe, a test board, or the DUT itself within the chamber) supplied by a tester/AWG 130 that generates one or more AC waveforms, *Vₛ*(*t*) (e.g., a test signal) to be delivered to the test probe, test board, or DUT itself. The cancellation amplifier 110 may drive (e.g., via a control circuit) an amplitude modulated current in each of the three wire loops 120x, 120y, 120z independently with one or more AC waveforms, *V_{H}*(*t*)*,* which may be synchronized to the tester/AWG 130 by a reference signal associated with the test signal. By driving a modulated current in the wire loops 120x, 120y, 120z that is based on the test signal generated by the tester/AWG 130 and provided within the chamber, the three wire loops 120x, 120y, 120z may generate a magnetic field with components in corresponding x, y, and z directions that operate together to cancel the magnetic field interference generated by the AC test signals supplied within the chamber from the tester/AWG 130. Because the control circuit may independently tune the modulation of the current in each of the wire loops 120x, 120y, 120z, the magnetic fields components in the corresponding x, y, and z directions may be tuned to match the interference magnetic field with components in the corresponding x, y, and z directions generated by the test signal(s) within the chamber from tester/AWG 130.

As should be understood, while three wire loops and three directions are shown in the example of FIG. 1, any number of wire loops may be used (e.g., one or more) to provide cancellation in one or more directions. In addition, while the directions shown in the example of FIG. 1 are orthogonal so that the components of the magnetic field generated in each wire loop 120x, 120y, 120z would (in an ideal case) not impact each other (e.g., the component of magnetic field generated by one loop does not have a component other directions), the wire loops need not be orthogonal and the component(s) of the generated magnetic field from each wire loop may be in overlapping directions.

In a typical FI system, the nP probes or internal test interface unit (TIU) is driven with a test signal provided by test equipment (such as tester/AWG 130, which may be a tester, a function generator, an arbitrary waveform generator, etc.) that is located outside of the tool's chamber and feeds the test signal(s) to the nP probes or internal TIU within the chamber. The AC test signals generate IEMI within the chamber that would otherwise distort the images created by the SEM. To cancel the IEMI, the signal generator(s) for the wire loops (e.g., cancellation amplifier 110) may generate a cancellation field *a priori* instead of needing to detect the AC-caused IEMI fields within the chamber and then feeding the detected IEMI fields back to the cancellation amplifier 110 (as would be done with external EMI). By modulating a compensation signal to generate the cancellation field *a priori,* the control circuit of the cancellation amplifier 110 may replicate the reciprocal of the specific voltage of the test signal supplied by the tester/AWG 130 to the DUT and feed the modulated signal to each wire loop 120x, 120y, 120z independently. The control circuit of the cancellation amplifier 110 may scale the magnitude of the current signals in each coil to diminish or exaggerate the cancellation field on each corresponding axis of the compensation magnetic field as needed. The combined components of the magnetic field created by the cancellation amplifier 110 with the wire loops 120x, 120y, 120z may then be tuned to cancel the IEMI-induced distortions observed in the SEM images.

There are several possibilities for how the control circuit of the cancellation amplifier 110 may be implemented, depending on the specific tool and application in which IEMI is observed. In general, the control circuit of the IEMI cancellation amplifier may register the test signals supplied to the probes or test boards (e.g., via a reference signal) and generate, based on the test signal and/or reference signal, a compensation signal that generates a reciprocal field for any IEMI. In this manner, the control circuit may produce for each channel of the cancellation amplifier 110 (e.g., where a channel corresponds to each wire loop) an independent arbitrary waveform that is in sync with the electrical equipment (e.g., tester/AWG 130) used to supply the test signal(s) to the test boards or probes within the chamber of the FI tool.

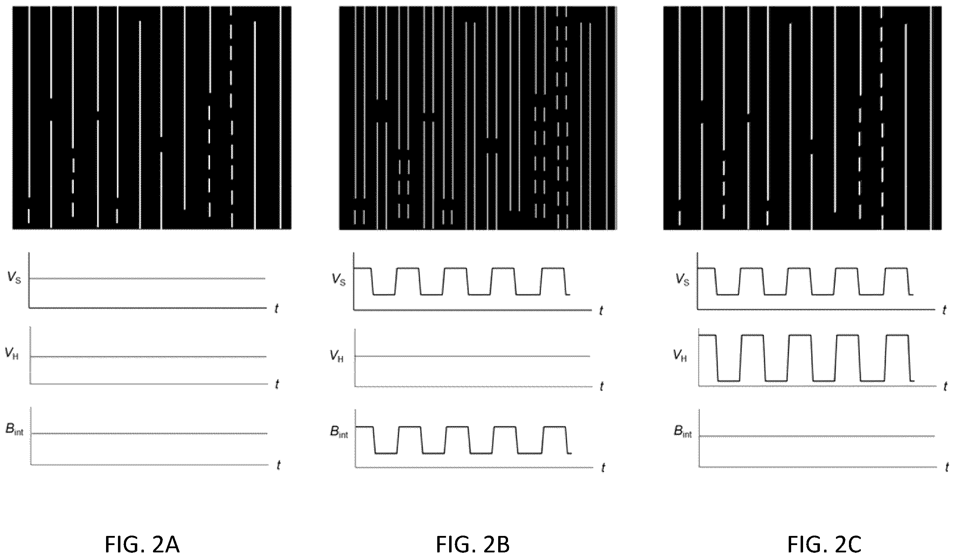

For nP AC-CLP applications, the AC field producing IEMI may be created by a single probe within the nP chamber. An example of such an application is displayed in the series of SEM images and waveforms in FIGs. 2A-2C. In FIG. 2A, the SEM image is shown, where there is no AC test signal driving the probe within the chamber (the AC component of *V*_{S} = 0) and the metal lines (vertical lines) in the SEM image have no IEMI distortion because the internal magnetic field (***B***ᵢₙₜ) has no AC components. When the test probe within the chamber is carrying an AC square wave test signal as shown for *V*_{S} in FIG. 2B, ***B***ᵢₙₜ has a temporally square magnitude with the same frequency as *V*_{S}. This is why the resultant SEM image in FIG. 2B shows doubled features-because the SEM beam is being toggled between two centers by ***B***ᵢₙₜ. To cancel this square field, as shown in FIG. 2C, a control circuit of the cancellation amplifier (e.g., cancellation amplifier 110) may drive a current on the wire coils used for IEMI cancellation (*V*_{H}) with an amplitude modulated square wave having approximately the same frequency as *V*_{S}. As noted above, the frequency of the test signal may be determined based on a reference signal from the test equipment (e.g. from tester/AWG 130 of FIG. 1) and/or by having a manual user interface on the amplifier (e.g., cancellation amplifier 110) so that the user may edit/enter the frequency manually that is to be used for the amplitude modulation of *V*_{H}. In addition, *V*_{S} and *V*_{H} may be phase-locked to one another by an electrical sync signal shared between the IEMI cancellation amplifier and the test equipment (e.g., which may be or be in addition to the reference signal). The user interface may allow a user to adjust the IEMI cancellation amplifier to gradually scale the magnitude of the modulated signal driven on each wire loop while actively using the SEM image as a feedback to determine what *V*_{H} scales may be needed to cancel the field in each of the available directions (e.g., on each of the three axis defined by a three-loop cancellation coil in orthogonal axial directions). With proper *V*_{H} tuning, ***B***ᵢₙₜ may be returned to a flat signal (e.g., canceled) and the double image in the SEM image may be diminished/eliminated, as shown in FIG. 2C, where the SEM image again has high fidelity, even with a square wave applied on *V*_{S}.

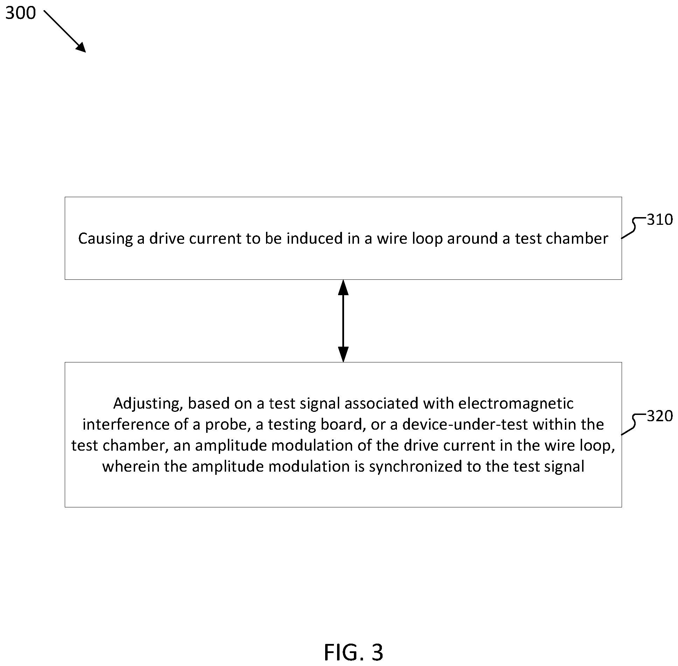

FIG. 3 shows a schematic flow diagram of a method 300 for cancelling an internal magnetic field caused by a test signal within a test chamber of a scanning electron microscope. Method 300 may implement any of the features associated with cancelling an internal magnetic field caused by a test signal within a test chamber of an SEM discussed above and/or with respect to FIGs. 1-2. Method 300 includes, in 310, causing a drive current to be induced in a wire loop around a test chamber. Method 300 includes, in 320, adjusting, based on a test signal associated with electromagnetic interference of a probe, a testing board, or a device under test within the test chamber, an amplitude modulation of the drive current in the wire loop, wherein the amplitude modulation is synchronized to the test signal.

In the following, various examples are provided that may include one or more features of cancelling an internal magnetic field caused by a test signal within a test chamber of a scanning electron microscope discussed above. It may be intended that aspects described in relation to the devices may apply also to the described method(s), and vice versa.

Example 1 is a device including a set of one or more wire loops around a test chamber, an amplifier configured to drive a current in each wire loop of the set of one or more wire loops, and a control circuit configured to adjust, via the amplifier, a corresponding amplitude modulation of the current in each wire loop, wherein the control circuit is configured to adjust the corresponding amplitude modulation based on a test signal within the test chamber.

Example 2 is the device of example 1, wherein the set of one or more wire loops include a plurality of wire loops, wherein the current in each loop may be driven independently from each other loop of the plurality of wire loops.

Example 3 is the device of any one of examples 1 to 2, wherein the set of one or more wire loops are configured to generate a magnetic field configured to cancel a internal magnetic field caused by the test signal within the test chamber.

4 is the device of any one of examples 1 to 3, wherein the set of one or more wire loops include a first loop, a second loop, and a third loop oriented in different directions that are configured to, when driven by the current, generate a magnetic field with respective components in a first field direction, a second field direction, and a third field direction.

Example 5 is the device of any one of examples 1 to 4, wherein the set of one or more wire loops include a set of one or more Helmholtz coils oriented in different directions with respect to one another.

Example 6 is the device of any one of examples 1 to 5, wherein the test signal includes an alternating current (AC) signal associated with a probe, a testing board, or a device under test within the test chamber.

Example 7 is the device of any one of examples 1 to 6, wherein the test chamber is of a scanning electron microscope (SEM), wherein the test signal is received from a signal generator used to excite a device under test loaded on the SEM.

Example 8 is the device of any one of examples 1 to 7, wherein a control circuit is configured to adjust the corresponding amplitude modulation based on a waveform of the test signal.

Example 9 is the device of example 8, wherein the waveform includes a patterned waveform that repeats at a frequency, wherein the corresponding amplitude modulation is configured to repeat at the frequency.

Example 10 is the device of example 9, wherein the patterned waveform includes a sinusoidal shape, a square shape, a triangular shape, a sawtooth shape, or an arbitrary shape.

Example 11 is the device of any one of examples 1 to 10, wherein the control circuit is configured to synchronize the corresponding amplitude modulation to the test signal based on a reference signal associated with the test signal.

Example 12 is the device of any one of examples 1 to 11, wherein the control circuit is configured to synchronize a timing of the corresponding amplitude modulation to a timing of the test signal based on a trigger associated with the test signal, wherein the trigger includes a beginning of a test pattern of the test signal, an end of a preamble of the test pattern, or an end of a reset of the test pattern.

Example 13 is the device of any one of examples 1 to 12, wherein control circuit is configured to synchronize the corresponding amplitude modulation to the test signal based on a reference signal received from a signal generator that is configured to generate the test signal.

Example 14 is the device of any one of examples 1 to 13, wherein the test signal is associated with an electromagnetic field generated by a probe, a testing board, or a device under test within the test chamber.

Example 15 is the device of any one of examples 1 to 14, wherein the corresponding amplitude modulation of the current in each loop is configured to generate a magnetic field that compensates for an electromagnetic field generated by a probe, a testing board, or a device under test within the test chamber.

Example 16 is a device including a processor configured to cause a drive current to be induced in a wire loop around a test chamber and to adjust, based on a test signal associated with electromagnetic interference of a probe, a testing board, or a device under test within the test chamber, an amplitude modulation of the drive current in the wire loop, wherein the amplitude modulation is synchronized to the test signal.

Example 17 is the device of example 16, wherein the processor configured to synchronize the amplitude modulation to the test signal based on a reference signal from a signal generator that supplies the test signal to the probe, the testing board, or the device under test.

Example 18 in apparatus for reducing interference from a testing signal within a testing chamber of a scanning electron microscope, the apparatus including a means for driving a current in a wire loop around the test chamber and a means for adjusting, based on a reference signal, an amplitude modulation of the current in the wire loop, wherein the reference signal is associated with a generation of the testing signal.

Example 19 is the apparatus of example 18, wherein the wire loop includes a Helmholtz coil.

Example 20 is the apparatus of any one of examples 18 to 19, wherein the testing signal includes an alternating current signal associated with a probe, a testing board, or a device under test within the test chamber.

While the disclosure has been particularly shown and described with reference to specific aspects, it should be understood by those skilled in the art that various changes in form and detail may be made therein without departing from the spirit and scope of the disclosure as defined by the appended claims. The scope of the disclosure is thus indicated by the appended claims and all changes, which come within the meaning and range of equivalency of the claims, are therefore intended to be embraced.

## Claims

1. A device comprising:
a set of one or more wire loops around a test chamber;
an amplifier configured to drive a current in each wire loop of the set of one or more wire loops; and
a control circuit configured to adjust, via the amplifier, a corresponding amplitude modulation of the current in each wire loop, wherein the control circuit is configured to adjust the corresponding amplitude modulation based on a test signal within the test chamber.

2. The device of claim 1, wherein the set of one or more wire loops comprise a plurality of wire loops, wherein the current in each loop may be driven independently from each other loop of the plurality of wire loops.

3. The device of any one of claims 1 or 2, wherein the set of one or more wire loops are configured to generate a magnetic field configured to cancel a internal magnetic field caused by the test signal within the test chamber.

4. The device of any one of claims 1 to 3, wherein the set of one or more wire loops comprise a first loop, a second loop, and a third loop oriented in different directions that are configured to, when driven by the current, generate a magnetic field with respective components in a first field direction, a second field direction, and a third field direction.

5. The device of any one of claims 1 to 4, wherein the set of one or more wire loops comprise a set of one or more Helmholtz coils oriented in different directions with respect to one another.

6. The device of any one of claims 1 to 5, wherein the test signal comprises an alternating current (AC) signal associated with a probe, a testing board, or a device under test within the test chamber.

7. The device of any one of claims 1 to 6, wherein the test chamber is of a scanning electron microscope (SEM), wherein the test signal is received from a signal generator used to excite a device under test loaded on the SEM.

8. The device of any one of claims 1 to 7, wherein a control circuit is configured to adjust the corresponding amplitude modulation based on a waveform of the test signal.

9. The device of claim 8, wherein the waveform comprises a patterned waveform that repeats at a frequency, wherein the corresponding amplitude modulation is configured to repeat at the frequency.

10. The device of claim 9, wherein the patterned waveform comprises a sinusoidal shape, a square shape, a triangular shape, a sawtooth shape, or an arbitrary shape.

11. The device of any one of claims 1 to 10, wherein the control circuit is configured to synchronize the corresponding amplitude modulation to the test signal based on a reference signal associated with the test signal.

12. The device of any one of claims 1 to 11, wherein the control circuit is configured to synchronize a timing of the corresponding amplitude modulation to a timing of the test signal based on a trigger associated with the test signal, wherein the trigger comprises a beginning of a test pattern of the test signal, an end of a preamble of the test pattern, or an end of a reset of the test pattern.

13. The device of any one of claims 1 to 12, wherein control circuit is configured to synchronize the corresponding amplitude modulation to the test signal based on a reference signal received from a signal generator that is configured to generate the test signal.

14. The device of any one of claims 1 to 13, wherein the test signal is associated with an electromagnetic field generated by a probe, a testing board, or a device under test within the test chamber.

15. The device of any one of claims 1 to 14, wherein the corresponding amplitude modulation of the current in each loop is configured to generate a magnetic field that compensates for an electromagnetic field generated by a probe, a testing board, or a device under test within the test chamber.
